# EUROPEAN PATENT APPLICATION

(11) **EP 1 308 541 A1**
(43) Date of publication of application: **07.05.2003**
(21) Application number: 01308480.1
(22) Date of filing: 04.10.2001
(51) Int. Cl.: C25D 3/38, C25D 3/02, C25D 3/26, C23C 18/16

(54) **Plating bath and method for depositing a metal layer on a substrate**

(71) Applicant: Shipley Company LLC, Marlborough, MA 01752 (US)
(72) Inventor: Cobley, Andrew J., Coventry, West Midlands, CV5 9EY (GB); Kapeckas, Mark J., Marlborough, Massachusetts 01752 (US); Reddington, Erik, Ashland, Massachusetts 01568 (US); Sonnenberg, Wade, Edgartown, MA 02539 (US); Gabe, David R., Loughborough, LE11 3TA (GB); Buckley, Thomas, Dedham, Massachusetts 02026 (US); Barstad, Leon R., Raynham, Massachusetts 02767 (US)
(74) Representative: Kent, Venetia Katherine

(57) **Abstract**

A metal plating bath and method for plating a metal on a substrate. The metal plating bath contains hydroxylamines that inhibit the consumption of additive bath components to improve the efficiency of metal plating processes. The additive bath components are added to metal plating baths to improve brighteness of plated metal as well as the micro-throwing and macro-throwing power of the bath. In addition to brighteners, the additive bath components may include levelers, suppressors, hardeners, and the like. The hydroxylamines that inhibit additive consumption may be employed in metal plating baths for plating copper, gold, silver, platinum, palladium, cobalt, cadmium, nickel, bismuth, indium, tin, rhodium, iridium, ruthenium and alloys thereof.

## Description

### BACKGROUND OF THE INVENTION

The present invention is directed to a plating bath and method for improving deposition of a metal on a substrate. More specifically, the present invention is directed to a plating bath and method for improving deposition of a metal on a substrate by including hydroxylamines in the plating bath that prevent the degradation of plating bath components.

Deposition of a metal on a substrate is used in a variety of industrial applications such as electroforming, electrorefining, manufacture of copper powder, electroplating, electroless plating and the like. The process of plating a substrate with a metal is used in the production of decorative articles for sanitary appliances, automobile parts, jewelry and furniture fittings, many electrical devices and circuits such as printed wiring and circuit boards, electrolytic foil, silicon wafer plating, and the like. Examples of metals that may be plated on a substrate include copper, gold, silver, palladium, platinum, zinc, tin, nickel, lead, cobalt and alloys thereof. Although many metals are employed in plating in the production of decorative articles and electrical devices, copper is one of the most common metals plated. The electronics industry extensively employs copper as a metal in the manufacture of printed wiring and circuit boards as well as other electronic articles.

The electronics industry has a number of requirements for copper deposits on printed wiring boards. For example, copper layers can not form any cracks when subject to thermal shock (immersed at least once for 10 sec. in liquid tin/lead solder at 288° C). In addition, the copper layers must be smooth, and as uniformly thick at all locations of a coated surface. Also, deposition procedures must be easy to manage and economical.

Anodes, such as copper anodes, that may decompose during electroplating are often used in the electroplating of copper. Such anodes are known in the industry as soluble anodes. Soluble anodes may be in the form of plates, bars or spheres. The plates and bars are connected to a power supply with a suitable fastening means. The spheres come in baskets that often consist of titanium. The spheres are connected to a power supply with suitable fastening means. Such anodes decompose at about the same rate during deposition as the copper is deposited from the deposition bath, the amount of copper in the deposition solution remains about constant. Thus, copper replenishment is not necessary.

Another type of anode is the insoluble anode. Exterior dimensions of insoluble anodes do not change during metal deposition process. Such anodes consist of inert materials such as titanium or lead that can be coated with catalytic metals such as platinum to prevent high anodic overvoltages. Insoluble anodes are preferred over the soluble anodes in the production of printed wiring and circuit boards. Electroplating processes employing insoluble anodes are more versatile than those using consumable electrodes, permit higher plating speeds, require smaller apparatus size and ease of maintenance, improved solution flow and agitation, and insoluble anodes may be placed close to cathodes. Particularly advantageous is the fact that the insoluble anode does not change size (i.e., cell geometry remains fixed). Thus, more uniform plating results are obtained. In addition, copper salts used to provide a source of copper are often available as products of etching procedures associated with the production of copper plated devices. For example, in the production of circuit boards, a copper layer is put down over an entire surface of an insulating substrate and part of the copper etched off to produce the circuit board of interest.

Plating metal on a substrate, such as electroplating with copper, is used extensively in a variety of manufacturing procedures. Copper plating is used to prevent corrosion on various surfaces (i.e., iron surfaces), as a binding layer for additional metal layers, to increase electrical or thermal conductivity and to provide conducting paths in many electrical applications. Electroplating with copper is employed in the manufacture of electrical devices such as circuit boards, integrated circuits, electrical contact surfaces and the like.

Plating metal is a complex process that involves multiple ingredients in a plating bath. In addition to metal salts that provide a source of metal, pH adjusters and surfactants or wetting agents, many plating baths, such as electroplating baths, contain chemical compounds that improve various aspects of the plating process. Such chemical compounds or additives are auxiliary bath components that are used to improve the brightness of the metal plating, the physical properties of the plated metal especially with respect to ductility and the micro-throwing power as well as the macro-throwing power of the electroplating bath. Of main concern are additives that have an effect on the bright finish, leveling and uniformity of metal deposition on surfaces. Maintaining bath concentrations of such additives within close tolerances is important to obtain high quality metal deposits. Such additives do breakdown during metal plating. The additives breakdown due to oxidation at the anode, reduction at the cathode and by chemical degradation. When additives breakdown during plating, the breakdown products may result in metal layer deposit characteristics that are less than satisfactory for industry standards. Regular additions of additives based upon empirical rules established by workers in the industry to try and maintain optimum concentrations of the additives have been employed. However, monitoring the concentrations of the additives that improve metal plating is still very difficult because the additives are present in small concentrations, i.e., parts per million of solution, in the plating baths. Also the complex mixtures of the additives and the degraded products formed from the additives during plating complicate the replenishment process. Further, depletion of specific additives is not always constant with time or bath use. Accordingly, the concentration of the specific additives is not accurately known and the level of the additives in the bath eventually diminishes or increases to a level where the additives are out of the acceptable range of tolerance. If the additive content goes too far out of the range of tolerance, the quality of the metal deposit suffers and the deposit may be dull in appearance and/or brittle or powdery in structure. Other consequences include low throwing power and/or plating folds with bad leveling. Electroplating of through-hole interconnections in the manufacture of multi-layer printed circuit boards is an example of where high quality plating is required.

Stability and lifetime of a plating bath is very important. Increased stability of the additives that improve metal plating leads to longer lifetimes for plating baths. Plating baths having longer lifetimes are economically very important. Frequent replacement of plating baths, as mentioned above, as well as disposal of baths containing degraded additives interrupts metal plating operations. Such interruptions reduce product yield. Accordingly, stable plating baths where breakdown of the additives is prevented or reduced, are highly desirable.

U.S. Pat. No. 4,469,564 discloses a copper electroplating process that allegedly increases the electroplating bath lifetime. The patent states that the process may be employed with a soluble or insoluble anode. A cation-permeable membrane surrounds the anode to prevent organic additives from contacting the anode and being oxidized by the anode. A disadvantage to such a process is that the cation-permeable membranes are exposed to corrosive chemicals for long periods of time that may cause the membranes to decompose. For example, bath pH ranges may be less than 1.0 to as high as 11.0 and higher. Also, bath pH ranges may fluctuate over time as bath components are consumed or breakdown. Thus, workers in the art must be selective in choosing a membrane with a chemical composition that does not breakdown due to pH fluctuations during electroplating. Additionally, as discussed above, electroplating baths contain a variety of components. Components such as the organic additives or their breakdown products may block pores in the cation-permeable membrane preventing passage of cations through the bath. Thus, workers must shut down the electroplating process and replace the membrane. Both blockage of the pores and shutting down the process lead to inefficiency in metal electroplating.

Japanese Patent Application 63014886 A2 discloses an acid copper electroplating bath with chloride ions and also containing transition metal ions in amounts of from 0.01-100g/l. The electroplating bath allegedly does not suffer from organic additive consumption. Such organic additives include brighteners, leveling agents, hardener, malleability and ductility modifiers, and deposition modifiers.

EP 0402 896 discloses a method of stabilizing an organic additive, such as a brightener, in an acid copper electroplating solution. The process employs a soluble anode of copper chips in a titanium basket. Transition metal salts of manganese, iron, chromium, and titanium are added to the electroplating solution in concentrations of not more than 5g/l. The transition metals may exist in at least two positive oxidation states, but are substantially present in solution in their lowest common positive oxidation state. The presence in solution of the positive oxidation states of the transition metal ions allegedly stabilizes the organic additives.

U.S. Pat. No. 6,099,711 discloses an electroplating process employing an insoluble anode where metal ions, such as copper ions, are replenished in the electroplating bath by employing a metal ion generator in the form of a reversible redox system. Because an insoluble anode is employed instead of a soluble anode, metal ions are not replenished in the bath by dissolution of the anode. Thus, the reversible redox system replenishes the metal ions. Iron (II) and iron (III) compounds are used as an electrochemically reversible redox system. Other redox systems disclosed in the patent include metals of titanium, cerium, vanadium, manganese and chrome. Such metals may be added to a copper depositing solution in the form of iron (II) sulfate-heptahydrate, iron (II) sulfate-nonahydrate, titanyl-sulfuric acid, cerium (IV) sulfate, sodium metavanadate, manganese (II) sulfate or sodium chromate. The patent states that the redox systems may be combined.

In addition to replenishing metal ions in the electroplating bath, the patent states that the process prevents degradation of organic additives to a significant extant. Degradation of large amounts of organic additives in a bath occurs electrolytically at the anode due to the anode potentials. Workers in the art believe that the potential of the iron (II) to Iron (III) redox reaction (about 0.530 V vs. SCE) provides an anode potential low enough to prevent brightener oxidation at the anode. Thus, brightener consumption is reduced. Such organic additives include brighteners, levelers, and wetting agents. Brighteners that are employed include water-soluble sulfur compounds and oxygen-containing high-molecular weight compounds. Other additive compounds include nitrogenous sulfur compounds, polymeric nitrogen compounds and/or polymeric phenazonium compounds.

Although the patent alleges to replenish metal ions and to reduce brightener consumption, the process, disclosed in the '711 patent, has disadvantages. Iron (III) may be reduced back to iron (II) in the reversible redox reaction instead of oxidizing copper to copper (II). Additionally, there is the problem that iron may build-up in the system over time requiring shut down and cleaning operations. Such operations reduce the efficiency of the process, and raise the cost of the process. Another disadvantage to the process is that the concentrations of the compounds in the redox system must be arranged in such a way that a constant concentration of metal ions is maintained in the deposition solution. Thus, there is a narrow or nonexistent margin of error in the concentrations of redox compounds in the deposition solution for the process to operate. Accordingly, minor changes in the concentrations of the redox compounds may hinder the operation of the process.

Japanese Patent Application 96199385 discloses an electroplating method and solution containing fluoride-based surfactants and organic additives such as brighteners. Addition of the fluoride-based surfactants allegedly prevents brightener consumption.

Although there are methods for preventing the degradation of additives in metal plating baths, there is still a need for additional methods of preventing the degradation of bath additives.

### SUMMARY OF THE INVENTION

The present invention is directed to a plating bath containing hydroxylamines that inhibit the consumption of additives in the plating bath, and a method of plating a metal on a substrate employing the plating baths. Such hydroxylamines include compounds having the following formula:

(R¹-NHR²OH)ₙX

where R¹ and R² are each independently hydrogen, or C₁-C₆ alkyl, and n is 1 or 2, when n is 1, X is HSO₄⁻, H₂PO₄⁻, NO₃⁻, F, Cl⁻, Br⁻ or I⁻, and when n is 2, X is SO₄²⁻.

The foregoing hydroxylamines may be employed in metal plating baths for plating copper, gold, silver, palladium, platinum, cobalt, cadmium, chromium, nickel, bismuth, indium, tin, rhodium, lead, iridium, ruthenium, or alloys thereof.

Advantageously, addition of the hydroxylamines to a plating bath prevents or reduces degradation of metal plating bath additives. Thus, the hydroxylamines provide for a plating bath that has a long life, and a method of metal plating that is efficient. Also, because the hydroxylamines of the present invention prevent degradation of the additives, plating baths of the present invention provide for uniform, high brightness metal layers with good physical-mechanical characteristics on substrates.

Metal plating baths of the present invention may be employed to plate metal layers on any substrate that may be metal plated. Metal plating methods of the present invention involve passing a current between two electrodes immersed in a bath containing dissolved plating metal, bath additives and one or more hydroxylamine consumption inhibiting compounds of the present invention. Current is passed through the bath until a substrate is plated with a desired thickness of metal.

The hydroxylamines and methods of the present invention may be employed in any industry where metal plating is used. For example, the metal plating baths may be employed in the manufacture of electrical devices such as printed circuit and wiring boards, integrated circuits, electrical contact surfaces and connectors, electrolytic foil, silicon wafers for microchip applications, semi-conductors and semi-conductor packaging, lead frames, optoelectronics and optoelectronics packaging, solder bumps such as on wafers, and the like. Also, the metal plating baths may be employed for metal plating decorative articles for jewelry, furniture fittings, automobile parts, sanitary appliances, and the like. Further, the hydroxylamines also may be employed in waste treatment methods.

The present invention also includes an apparatus composed of an electrical power source, an anode, a cathode, and a metal plating bath containing hydroxylamine consumption inhibiting compounds. The cathode of the apparatus is the article that is metal plated. The apparatus may be a vertical or a horizontal metal plating apparatus.

A primary objective of the present invention is to provide hydroxylamines that prevent or reduce degradation of additives in a metal plating bath.

Another objective of the present invention is to provide a metal plating bath that has a long operating life.

An additional objective of the present invention is to provide for an efficient method for plating a metal on a substrate.

A further objective of the present invention is to provide a method for plating a uniform, high brightness metal layer with good physical-mechanical properties on a substrate.

Still yet another objective of the present invention is to provide an apparatus containing a hydroxylamine metal plating bath.

Additional objectives and advantages may be ascertained by a person of skill in the art after reading the detailed description of the invention and the appended claims.

### BRIEF DESCRIPTION OF THE DRAWINGS

FIG. 1 is a diagrammatic illustration of an apparatus for treating a workpiece by the vertical method in accordance with the present invention; and
FIG. 2 is a diagrammatic illustration of an apparatus for treating a workpiece by the horizontal method in accordance with the present invention.

### DETAILED DESCRIPTION OF THE INVENTION

Metal plating baths of the present invention contain hydroxylamines that prevent or reduce the consumption of additives added to metal plating baths to improve metal deposition on a substrate. The metal plating baths may be employed in any suitable process for plating a metal on a substrate. Such hydroxylamines have the following formula:

(R¹-NHR²OH)ₙX

where R¹ and R² are each independently hydrogen or C₁-C₆ alkyl, and n is 1 or 2, when n is 1, X is HSO₄⁻, H₂PO₄⁻, NO₃⁻, F, Cl⁻, Br⁻, or I⁻ and when n is 2, X is SO₄²⁻. The C₁-C₆ alkyl may be exemplified by methyl, ethyl, propyl, isopropyl, butyl, isobutyl, sec-butyl, tert-butyl, pentyl, isopentyl, neopentyl, tert-pentyl, hexyl, isohexyl, 3-methylpentyl, 2,2-dimethylbutyl, and 2,3-dimethylbutyl.

Preferred hydroxylamines are hydroxylamines where R¹ and R² are hydrogen such as hydroxylamine sulfate, hydroxylamine nitrate and hydroxylamine chloride. The most preferred are hydroxylamine sulfate and hydroxylamine nitrate. The foregoing additive consumption inhibiting compounds may be obtained commercially or may be synthesized according to methods well known in the art.

The foregoing compounds may be employed in metal plating baths for plating copper, gold, silver, palladium, platinum, cobalt, chromium, cadmium, nickel, bismuth, indium, tin, iridium, ruthenium, rhodium, lead or alloys thereof. Preferably, the foregoing compounds may be employed in metal plating baths for plating metals consisting of copper, gold, platinum, silver, palladium, iridium, ruthenium, and cobalt. More preferably, the foregoing additive consumption inhibiting compounds are employed in metal plating baths for plating copper, iridium, and ruthenium. Most preferably, the metal plating bath is for plating copper. Such metals are included in the metal plating baths as their water soluble salts.

Adding one or more of the hydroxylamines to metal plating baths prevent or reduce the degradation of additives in the metal plating baths. Preferably, the metal plating baths are electroplating baths. The hydroxylamines are added in amounts of generally from about 0.001g/L to about 100 g/L of bath. Preferably, the compounds are generally employed in plating baths of from about 0.01 g/L to about 20.0 g/L. The additive preserving hydroxylamine compounds may be added to plating baths by any suitable method employed to add components to a bath. One method is to admix the hydroxylamines into the plating bath with the other bath components and additives.

Additives that the hydroxylamines prevent degradation of or substantially reduce the amount of degradation include, but are not limited to, brighteners, levelers, hardeners, wetting agents, malleability, ductility and deposition modifiers, suppressors and the like. The additive preserving hydroxylamine compounds of the present invention are especially effective in preventing degradation of brighteners and levelers. While the hydroxylamines of the present invention may be employed to prevent the degradation of additives employed in various metal plating baths, the hydroxylamines are preferably employed to prevent the degradation of additives employed in copper baths.

Examples of suitable brighteners employed in plating baths of the present invention, include but are not limited to, compounds that contain structural formulas: HO₃S-R¹¹-SH, HO₃S-R¹¹-S-S-R¹¹-SO₃H, where R¹¹ is C₁-C₆ or an aryl group, and HO₃S-Ar-S-S-Ar-SO₃H, where Ar is phenyl or naphthyl. Substituents of the alkyl and aryl groups may be, for example, alkyl, halo and alkoxy. Examples of such brightening agents are 3-mercapto-propylsulfonic acid (sodium salt), 2-mercapto-ethanesulfonic acid (sodium salt), and bissulfopropyl disulfide (BSDS). Such compounds are disclosed in U.S. Pat. Nos. 3,770,598, 4,374,709, 4,376,685, 4,555,315 and 4,673,469, all incorporated herein in their entirety by reference. Such polysulfides also may be employed to increase ductility of deposited metal. Examples of other suitable brighteners, especially for copper baths, include N,N-dimethylthiocarbamic acid (3-sulfopropyl) ester, sodium salt (DPS), (O-ethyldithiocarbonato)-S-(3-sulfopropyl)-ester, potassium salt (OPX), 3-[(amino-iminomethyl)-thio]-1-propanesulfonic acid (UPS), 3-(2-benthiazolylthio)-1-propanesulfonic acid, sodium salt (ZPS) and the thiol of bissulfopropyl disulfide (MPS).

Examples of levelers that may be employed in a plating bath include, but are not limited to, alkylated polyalkyleneimines and organic sulfo sulfonates. Examples of such compounds include 1-(2-hydroxyethyl)-2-imidazolidinethione (HIT), 4-mercaptopyridine, 2-mercaptothiazoline, ethylene thiourea, thiourea and alkylated polyalkyleneimine. Such compounds are disclosed in U.S. Pat. Nos. 4,376,685, 4,555,315, and 3,770,598, the disclosures of which are hereby incorporated herein in their entireties by reference.

Examples of other additives that may function as brighteners in plating baths within the scope of the present invention include, but are not limited to, sulfur compounds such as 3-(benzthiazoyl-2-thio)-propylsulfonic acid sodium salt, 3-mercaptopropane-1-sulfonic acid sodium salt, ethylenedithiodipropylsulfonic acid sodium salt, bis-(p-sulfophenyl)-disulfide disodium salt, bis-(ω-sulfobutyl)-disulfide disodium salt, bis-(ω-sulfohydroxypropyl)-disulfide disodium salt, bis-(ω-sulfopropyl)-disulfide disodium salt, bis-(ω-sulfopropyl)-sulfide disodium salt, methyl-(ω-sulfopropyl)-disulfide sodium salt, methyl-(ω-sulfopropyl)-trisulfide disodium salt, O-ethyl-dithiocarbonic acid-S-(ω-sulfopropyl)-ester, potassium salt thioglycoli acid, thiophosphoric acid-O-ethyl-bis-(ω-sulfpropyl)-ester disodium salt, thiophosphoric acid-tris(ω-sulfopropyl)-ester trisodium salt, and the like.

Examples of oxygen containing high molecular weight compounds that may be employed as suppressors include carboxymethylcellulose, nonylphenolpolyglycol ether, octandiolbis-(polyalkylene glycolether), octanolpolyalkylene glycolether, oleic acidpolyglycol ester, polyethylenepropylene glycol, polyethylene glycol, polyethylene glycoldimethylether, polyoxypropylene glycol, polypropylene glycol, polyvinylalcohol, stearic acidpolyglycol ester, stearyl alcoholpolyglycol ether, polyethylene oxide and the like.

Dyes of the phenazine class (Safranine type) and phenazine azo dyes (Janus Green B type) may be employed as levelers. Polyethers are used to improve thickness and uniformity of metal plating.

Brighteners and levelers are added to plating baths in amounts of from about 1 part per billion to about 1.0 g/L of bath. Preferably, brighteners and levelers range from about 10 parts per million to about 500 parts per million. Ranges for bath components may vary from one bath composition to the next. Thus, the foregoing weight ranges for the additives are general ranges.

Examples of suitable wetting agents or surfactants that may be employed in plating baths of the present invention include nonionic surfactants such as alkyl phenoxy polyethoxyethanols. Other suitable wetting agents containing multiple oxyethylene groups also may be employed. Such wetting agents include compounds of polyoxyethylene polymers having from as many as 20 to 150 repeating units. Such compounds also may perform as suppressors. Also included in the class of polymers are block copolymers of polyoxyethylene and polyoxypropylene. Surfactants and wetting agents are added in conventional amounts.

In addition to the additives, other plating bath components are included in plating baths as a source of metal ions, pH adjusters, such as inorganic acids, and a source of halide ions. Generally, plating baths are aqueous. The pH range of the baths may range from 0 to about 14, preferably from 0 to about 8. Wetting agents employed in plating baths and amounts employed in such baths are well known in the art. Inorganic acids employed include, but are not limited to, sulfuric acid, hydrochloric acid, nitric acid, phosphoric acid and the like. Sulfuric acid is a preferred acid. Halogen ions are optional. Halogen ions employed in plating baths include chloride, fluoride, and bromide. Such halides are added into the bath as a water soluble salt. Chloride is preferred, and is introduced into the bath as sodium chloride, preferably as HCI. Water soluble salts of metals provide a source of the metal to be plated on a substrate. Such water soluble salts include metal salts of copper, nickel, chromium, gold, silver, cadmium, platinum, palladium, cobalt, bismuth, tin, rhodium, iridium, ruthenium, lead, and indium. Solder also may be plated with the plating baths of the present invention.

Copper is the preferred metal to be plated with the baths of the present invention. Preferably, the copper is electroplated. Copper that is useful may be in the form of any solution soluble copper compound. Suitable copper compounds include, but are not limited to, copper halides, copper sulfates, copper alkane sulfonate, copper alkanol sulfonate, and the like. When copper halide is used, chloride is the preferred halide. Preferred copper compounds are copper sulfate, copper alkane sulfonate, or mixtures thereof. The more preferred are copper sulfate, copper methane sulfonate or mixtures thereof. Copper compounds useful in the present invention are generally commercially available or may be prepared by methods known in the literature. When copper is plated on a substrate the pH of the bath may range from 0 to about 14. Preferably the bath ranges from a pH of from 0 to about 8.0.

Metal ions range in concentration in the plating baths of from about 0.010 g/L to about 200 g/L, preferably from about 0.5 g/L to about 100 g/L. When copper is employed the amount of copper may range from about 0.01 to about 100 g/L. Preferably copper is used in the bath in amounts from about 0.10 g/L to about 50 g/L. When the bath of the present invention is used in a non-high speed plating process, the amount of copper present in the bath ranges preferably from about 0.02 g/L to about 25 g/L. When the bath of the present invention is used in a high speed plating process, the amount of copper present in the bath ranges from about 1.0 g/L to about 100 g/L, preferably from about 2.0 g/L to about 50 g/L.

Halide ions, especially for copper baths, range in concentration of from 0 mg/L to about 1g/L, preferably from about 1.0 mg/L to about 150 mg/L. Acids are added to the plating baths to obtain a pH range of from about 0 to about 8.0, most preferably from about less than 1.0 to about 2.0. Accordingly, acids are added in amounts of from about 10 g/L to about 600 g/L, preferably from about 15 g/L to about 500 g/L.

An example of an acid copper electroplating bath for practicing the present invention has a composition as follows:

| | |
|---|---|
| Copper Ions (as Copper Sulfate) | 0.01 to 50 g/L |
| Sulfuric Acid (Concentrated) | 15 to 500 g/L |
| Chloride Ions (as Sodium Chloride) | 1 ppm to 150 ppm |
| Additives | As Required |
| Hydroxylamine sulfate | 0.1 to 10 g/L |
| Water | To 1 liter |

While the hydroxylamine compounds may be employed to prevent degradation of additives in any suitable plating bath where a substrate is to be metal plated, preferably, the additive preserving hydroxylamine compounds are employed in electroplating baths. Such electroplating baths are employed in electrodeposition of a metal on a substrate such as in the manufacture of printed wiring boards and silicon wafers used in microchip applications, and in the manufacture of other components for electrical devices. Electroplating processes involve passing current through an anode, an electroplating solution, and a cathode for a sufficient amount of time to metal plate a substrate to a desired thickness. The anode may be a soluble anode (composed of a metal such as copper that dissolves and replenishes the electroplating bath as plating occurs). Alternatively, an insoluble anode (composed of an inert material such as platinum, platinized titanium, lead, and the like) may be employed. Preferably, the present invention is employed in plating processes employing an insoluble anode where electroplating rates are greater and problems associated with additive consumption (often oxidation at the anode) are greater than with processes employing soluble anodes.

Examples of useful insoluble anodes are anodes that have surfaces with oxides of iridium and tantalum. Such anodes have from about 20 to about 90 moles percent of iridium with the remainder tantalum. Preferred is about 60 to about 90 mole percent of iridium with the remainder tantalum. The anodes are made by coating iridium and tantalum on a conducting substrate such as a titanium substrate.

Other suitable anodes include anodes composed of at least about 10 mole percent of group VIII metals, at least about 10 mole percent valve metal and at least about 5 mole percent binder metal. Group VIII metals include cobalt, nickel, ruthenium, rhodium, palladium, iridium and platinum. Valve metals include titanium, zirconium, hafnium, vanadium, niobium and tantalum. Binder metals include beryllium, calcium, strontium, barium, scandium, yttrium, lanthanum and rare earth elements with atomic numbers 58 through 71. Especially useful is an oxide composition with from about 5 to about 20 mole percent of barium, and the ratio of iridium to tantalum between about ¼ and about 4. Such a composition is about 5 mole percent barium, from about 30 to about 40 mole percent iridium with the remainder tantalum. Additionally, osmium, silver and gold or their oxides may be employed in insoluble anodes.

As mentioned above, plating baths of the present invention may be employed in any suitable plating process where metal is plated on a substrate. Examples of such plating processes include, but are not limited to, direct current (DC) electroplating and pulse electroplating plating. Plating baths of the present invention are especially suitable for plating substrates in the manufacture of electronic devices such as in the printed wiring board industry and the manufacture of silicon semiconductor wafers.

In an electroplating process, the substrate to be plated is used as a cathode. A soluble or preferably an insoluble anode, as described above, is employed as a second electrode. A process of pulse plating, DC (direct current) plating or a combination of both is employed. Such methods of plating are known in the art. Current densities and electrode surface potentials may vary depending on the specific substrate to be plated. Generally, anode and cathode current densities may vary within a range of from about 1 to about 1000 amps/ft² (ASF). Plating baths are maintained in a temperature range of from about 20° C to about 110° C. Specific ranges vary depending upon which metal is being plated. Such temperature ranges are well known in the art. Copper baths may range from about 20° C to about 80° C. Acid copper baths range in temperature of from about 20° C to about 50° C. Plating is continued for a time sufficient to form a deposit of desired thickness. Generally, plating time for a circuit board is from about 45 minutes to about 8 hours. For circuit board manufacture, a desired thickness may range from about 0.5 to about 3.0 mils. More often layer thickness ranges from about 1.0 to about 1.5 mils.

Both vertical and horizontal plating processes may be employed. In the vertical process, the substrate, such as a printed circuit or wiring board, is sunk in a vertical position into a container containing a plating bath solution of the present invention. The substrate, which functions as a cathode, is situated in the vertical position opposite at least one anode, preferably an insoluble anode. The substrate and the anode are connected to a current source. Instead of regulating the current density with the current source, there also can be a voltage arrangement where the voltage between the substrate and the anode is regulated. Plating solution is directed continuously through the container by means of transporting equipment such as a pump.

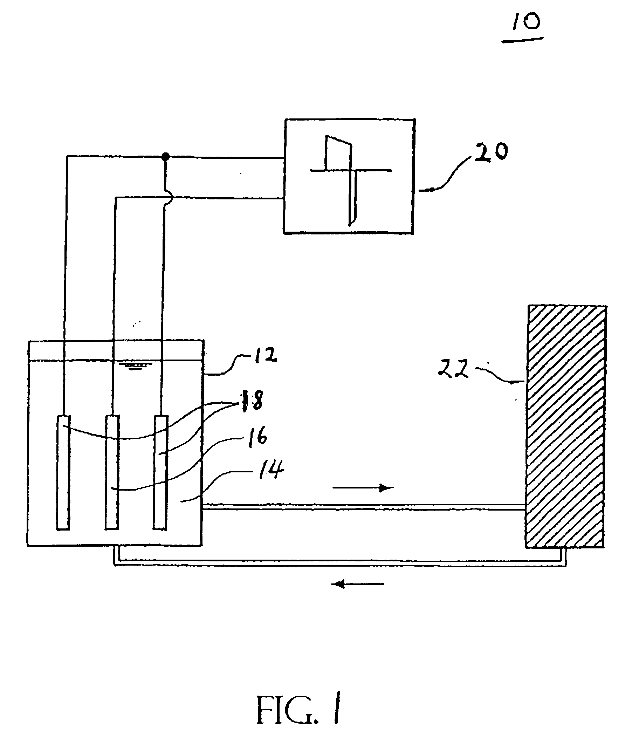

An example of an arrangement that is suitable for treating a substrate or workpiece by a vertical method and apparatus is represented in FIG. 1. Apparatus **10** is composed of container **12** with metal plating bath **14** that contains a hydroxylamine that prevents additive consumption. The metal plating bath **14** may be used, for example, for copper plating and contains previously mentioned components and additives.

Workpiece **16** (cathode), for example a circuit board, and anodes **18**, for example insoluble titanium anodes coated with iridium dioxide, are immersed into metal plating bath **14**. Workpiece **16** and anodes **18** are connected electrically to current source **20**. Instead of regulating the current with the current source, a voltage arrangement (not shown) may be used to regulate voltage between the workpiece **16** and anodes **18**. Metal plating bath **14** is directed continuously to second container or reservoir **22** by a transporting means (not shown) such as a pump. Reservoir **22**, which metal plating bath **14** flows through, replenishes metal bath components and additives in metal plating bath **14** such as copper salts, brighteners, levelers, hydroxylamine additive consumption inhibitors and the like.

In the horizontal plating process, the substrate is transported through a conveyorized unit in a horizontal position with a horizontal direction of movement. Plating bath is injected continuously from below and/or from above onto the substrate by means of splash nozzles or flood pipes. The anodes are arranged at a spacing relative to the substrate and are brought into contact with the plating bath by means of a suitable device. The substrate is transported by means of rollers or plates.

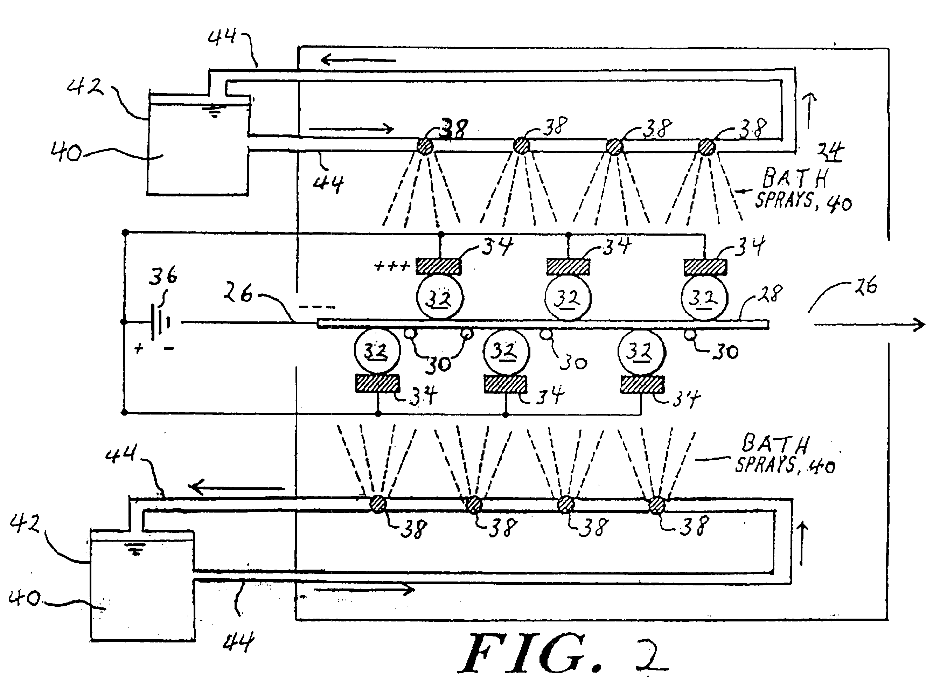

An example of a horizontal method and apparatus that may be employed to practice the present invention is illustrated in FIG. 2. Spray chamber **24** of apparatus **46** is formed with slots **26** at either end to allow for continuous conveyance of panel **28**, such as a circuit board panel to be metal plated, to enter and leave chamber **24**. While a circuit board panel is illustrated, any suitable surface that may be plated by a horizontal apparatus lies within the scope of the present invention. Panel **28** is supported for moving in the direction of the arrow by idler rollers **30**. A series of roller brushes **32** is positioned to contact both upper and lower surfaces of panel **28** with a series of anodes **34** positioned to contact roller brushes **32** on the side of idler rollers **30** away from panel **28**. Anodes **34** are formed of any suitable metal such as titanium coated with iridium dioxide. While any suitable anode may be employed, an insoluble anode such as the titanium coated iridium dioxide anode is preferred. Anodes **34** are positioned such that the anodes touch the upper set of idler rollers **30** from above, and touch the lower set of idler rollers **30** from below. All of anodes **34** are electrically connected in parallel to a positive terminal of power supply **36**. A negative terminal of power supply **36** is connected to panel **28** (cathode) that is to be plated. Spray jets **38** which are connected to reservoir **42** containing metal plating bath **40** by means of lines **44** are arranged to spray metal plating bath **40** down on both anodes **34** and roller brushes **32** as well as panel **28** between roller brushes **32**. Arrows show the path for the metal bath flow through lines **44**. Metal plating bath **40** is pumped from reservoir **42** through lines **44** by a pumping means (not shown) in mechanical connection to reservoir **42**. The transport mechanism means (not shown) for panel **28** is a conveyor-type mechanism that provides for a continuous movement of panel **28** through chamber **24** while maintaining electrical contact between the negative pole of power supply **36** and panel **28**.

By preventing or reducing the amount of additive breakdown, the hydroxylamine compounds provide for improved brightness of plated metal and improved physical-mechanical properties of the plated metal. Metal layers plated with baths of the present invention are not brittle or powdery in structure. Also, metal layers plated with the baths of the present invention have good throwing power and no appreciable plating folds. Such properties for metal layers are especially desirable for through-holes in printed circuit and wiring boards. Additionally, because the select compounds prevent or substantially reduce the amount of additives degraded during metal plating, replenishment of the additives is rarely, if ever, needed. Also, prevention of additive breakdown permits metal plating operations to continue for longer periods without bath replacement. Further, because the hydroxylamine compounds inhibit degradation of additives, costly semi-permeable membranes can be eliminated from apparatus during plating. Thus, plating baths containing the hydroxylamine compounds provide for a more efficient and economic method for metal plating than baths without the hydroxylamine compounds. Accordingly, metal plating baths of the present invention provide for an improved metal plating process. All numerical ranges disclosed above are inclusive and combinable.

While the present invention is described with an emphasis on electroplating processes in the printed wiring board industry, the present invention may be employed in any suitable plating process. The hydroxylamine compounds may be employed in metal plating baths in the manufacture of electrical devices such as printed circuit and wiring boards, integrated circuits, electrical contact surfaces and connectors, electrolytic foil, silicon wafers for microchip applications, semi-conductors and semi-conductor packaging, lead frames, optoelectronics and optoelectronic packaging, solder bumps such as on wafers, and the like. Additionally, the metal plating baths may be employed for metal plating decorative articles for jewelry, furniture fittings, automobile parts, sanitary appliances, and the like. Further, the additive consumption inhibiting compounds may be employed in waste treatment methods.

The following examples are provided to better describe the present invention, and are not intended to limit the scope of the invention.

### Example 1

Brightener consumption is determined in an electroplating bath using a Hull Cell. Each Hull Cell employed is a hydrodynamically controlled Hull Cell (HCHC). The bath is a copper plating bath containing the following components:

| | |
|---|---|
| Copper Sulfate Pentahydrate | 80 g/L |
| Sulfuric Acid (concentrated) | 225 g/L |
| Chloride (as sodium chloride) | 50 ppm |
| Bissulfopropyl Disulfide (brightener) | 1 mg/L |
| Water | To 1 L |

The first Hull Cell experiment has a soluble copper anode and a copper clad glass epoxy panel as a cathode. The second and third Hull Cells employed have an insoluble iridium dioxide anode in place of the soluble copper anode. In addition to the above bath components, the third Hull Cell contains about 1 g/L of hydroxylamine sulfate. Copper is plated on the copper clad glass epoxy cathode. Brightener consumption is measured as percent matte on the surface of plated copper. Matte as defined within the scope of the present invention means a dull or non-reflective surface appearance on the copper plated on the cathode.

Each Hull Cell experiment is operated at about 3 amps for about 2 minutes, and then for about 10 minutes. The percent matte on the plated copper surface is determined after about 2 minutes and after about 10 minutes. The first Hull Cell experiment with the soluble copper anode shows about the same percentage of matte on the copper metal after about 2 minutes as after about 10 minutes. Accordingly, very little brightener is consumed between about 2 minutes and about 10 minutes with a soluble copper anode.

In the second experiment where an iridium dioxide insoluble anode is used, about 30% of the copper metal is matte after about 2 minutes. After about 10 minutes, almost all of the copper metal is matte. Accordingly, after about 10 minutes almost all of the brightener is consumed with an insoluble iridium dioxide anode.

In the third experiment, about 1.0 gm/L of hydroxylamine sulfate is added to the copper plating bath to act as a brightener consumption inhibitor. The matte on the copper plated on the cathode is about the same percentage after both the about 2 minute period and the about 10 minute period. Accordingly, very little brightener is consumed between the about 2 minute period and the about 10 minute period.

Brightener consumption is especially problematic when an insoluble anode is employed in contrast to a soluble copper anode. However, when hydroxylamine sulfate is added to the copper plating bath with an insoluble anode, brightener consumption is inhibited.

## Claims

1. A metal plating bath comprising an additive consumption inhibiting compound having a formula:
(R¹-NHR²-OH)ₙX
where R¹ and R² are each independently hydrogen, C₁-C₆ alkyl, n is 1 or 2, when n is 1, X is HSO₄⁻, H₂PO₄⁻, NO₃⁻, F, Cl⁻, Br⁻ or I⁻ and when n is 2, X is SO₄²⁻; and metal salts of copper, gold, silver, palladium, platinum, cobalt, cadmium, chromium, nickel, bismuth, indium, tin, rhodium, lead, ruthenium, iridium, or alloys thereof.

2. The metal plating bath of claim 1, wherein the C₁-C₆ alkyl comprises methyl, ethyl, propyl, isopropyl, butyl, isobutyl, sec-butyl, tert-butyl, pentyl, isopentyl, neopentyl, tert-pentyl, hexyl, isohexyl, 3-methylpentyl, 2,2-dimethylbutyl, or 2,3-dimethylbutyl.

3. The metal plating bath of claim 1, wherein the additive consumption inhibiting compound comprises hydroxylamine sulfate, hydroxylamine nitrate, hydroxylamine chloride or mixtures thereof.

4. The metal plating bath of claim 1, wherein the additive consumption inhibiting compound comprises from about 0.001 g/L to about 100 g/L of the bath.

5. The metal plating bath of claim 4, wherein the additive consumption inhibiting compound comprises from about 0.01 g/L to about 20.0 g/L of the bath.

6. The metal plating bath of claim 1, further comprising additives comprising brighteners, levelers, hardeners, wetting agents, malleability modifiers, ductility modifiers, deposition modifiers, or suppressors.

7. The metal plating bath of claim 6, wherein the brighteners comprise compounds having the formulas: HO₃-S-R¹¹-SH; HO₃S-R¹¹-S-S-R¹¹-SO₃H, where R¹¹ is C₁-C₆ alky or an aryl group; or HO₃-Ar-S-S-Ar-SO₃H, where Ar is phenyl or naphthyl, the alky and aryl groups may be unsubstituted or substituted with an alkyl group, halo or alkoxy group.

8. The metal plating bath of claim 7, wherein the brighteners comprise 3-mercapto-propylsulfonic acid sodium salt, 2-mercapto-ethanesulfonic acid sodium salt, bissulfopropyl disulfide, N,N-dimethyldithiocarbamic acid (3-sulfopropyl) ester sodium salt, (O-ethyldithiocarbonato)-S-(3-sulfopropyl)-ester potassium salt, 3-[(amino-iminomethyl)-thio]-1-propanesulfonic acid, 3-(2-benzthiazolylthio)-1-propanesulfonic acid sodium salt or mixtures thereof.

9. The plating bath of claim 6, wherein the levelers comprise alkylated polyalkyleneimines, organo sulfo sulfones, dyes of the phenazine class, phenazine azo dyes, or mixtures thereof.

10. The plating bath of claim 6, wherein the brighteners comprise 3-(benzthiazoyl-2-thio)-propylsulfonic acid sodium salt, 3-mercaptopropane-1-sulfonic acid sodium salt, ethylenedithiodipropylsulfonic acid sodium salt, bis-(p-sulfopehnyl)-disulfide disodium salt, bis-(ω-sulfobutyl)-disulfide disodium salt, bis-(ω-sulfohydroxypropyl)-disulfide disodium salt, bis-(ω-sulfopropyl)-disulfide disodium salt, bis-(ω-sulfopropyl)-sulfide disodium salt, methyl-(ω-sulfopropyl) sodium salt, methyl-(ω-sulfopropyl)-trisulfide disodium salt, O-ethyl-dithiocarbonic acid-S-(ω-sulfopropyl)-ester, potassium salt thioglycolic acid, thiophosphoric acid-O-ethyl-bis-(ω-sulfopropyl)-ester disodium salt, thiophosphoric acid-tri(ω-sulfopropyl)-ester trisodium salt, or mixtures thereof.

11. The plating bath of claim 6, wherein the suppressors comprise carboxymethylcellulose, nonyphenolpolyglycol ether, octandiolbis-(polyalkylene glycolether), octanolpolyalkylene glycolether, oleic acidpolyglycol ester, polyethylenepropylene glycol, polyethylene glycol, polyethylene glycoldimethylether, polyoxypropylene glycol, polypropylene glycol, polyvinylalcohol, polyethylene oxide, stearic acidpolyglycol ester, stearyl alcoholpolyglycol ether, or mixtures thererof.

12. The metal plating bath of claim 1, wherein the bath has a pH of from 0 to about 14.0.

13. The metal plating bath of claim 12, wherein the bath has a pH of from 0 to about 8.0.

14. A copper metal electroplating bath comprising a copper salt, and an additive consumption inhibiting compound having the formula:
(R¹-NHR²OH)ₙX
where R¹ and R² are each independently hydrogen, C₁-C₆ alkyl, n is 1 or 2, when n is 1, X is HSO₄⁻, H₂PO₄⁻, NO₃⁻, F, Cl⁻, Br⁻, or I⁻, and when n is 2, X is SO₄²⁻.

15. The copper metal electroplating bath of claim 14, wherein the C₁-C₆ alky comprises methyl, ethyl, propyl, isopropyl, butyl, isobutyl, sec-butyl, tert-butyl, pentyl, isopentyl, neopentyl, tert-pentyl, hexyl, isohexyl, 3-methylpentyl, 2,2-dimethyl or 2,3-dimethylbutyl.

16. The copper metal electroplating bath of claim 14, wherein the additive inhibiting compound comprises hydroxylamine sulfate, hydroxylamine nitrate, hydroxylamine chloride, or mixtures thereof.

17. The copper metal electroplating bath of claim 14, wherein the additive consumption inhibiting compounds comprise from about 0.001 g/L to about 100 g/L of the bath.

18. The copper metal electroplating bath of claim 17, wherein the additive consumption inhibiting compounds comprise from about 0.01 g/L to about 20.0 g/L of the bath.

19. The copper metal electroplating bath of claim 14, further comprising additives comprising brighteners, levelers, hardeners, wetting agents, malleability modifiers, ductility modifiers, deposition modifiers, suppressors or mixtures thereof.

20. The copper metal electroplating bath of claim 19, wherein the brighteners comprise compounds having the structural formula: HO₃-S-R¹¹-SH; HO₃S-R¹¹-S-S-R¹¹-SO₃H, where R¹¹ is C₁-C₆ alkyl group or an aryl group; or HO₃-Ar-S-S-Ar-SO₃H, where Ar is phenyl or naphthal; the alkyl and aryl groups may be alkyl groups, halo or alkoxy.

21. The copper metal electroplating bath of claim 19, wherein the levelers comprise alkylated polyalkyleneimines, organic sulfo sulfonates, dyes of the phenazine class and phenazine azo dyes of mixtures thereof.

22. The copper metal electroplating bath of claim 19, wherein the copper metal salt comprises copper halides, copper sulfates, copper alkane sulfonate, copper alkanol sulfonate, or mixtures thereof.

23. The copper metal electroplating bath of claim 14, wherein the bath has a pH of from about 0 to about 8.0.

24. A method for plating a metal on a substrate comprising: contacting the substrate with a metal plating bath; and applying sufficient current density to the plating bath to deposit the metal on the substrate; the plating bath comprises a metal salt of the metal copper, gold, silver, palladium, platinum, cobalt, cadmium, chromium, nickel, bismuth, indium, tin, rhodium, iridium, ruthenium, lead, or alloys thereof, and an additive consumption inhibiting compound having the formula:
(R¹-NHR²OH)ₙX
where R¹ and R² are each independently hydrogen, C₁-C₆ alkyl, n is 1 or 2, when n is 1, X is HSO₄⁻, H₂PO₄⁻, NO₃⁻, F, Cl⁻, Br⁻, or I⁻, and when n is 2, X is SO₄²⁻.

25. The method of claim 24, wherein the C₁-C₆ alkyl comprises methyl, ethyl, propyl, isopropyl, butyl, isobutyl, sec-butyl, tert-butyl, pentyl, isopentyl, neopentyl, tert-pentyl, hexyl isohexyl, 3-methylpentyl, 2,2-dimethylbutyl, or 2,3-dimethylbutyl.

26. The method of claim 24, wherein the additive consumption inhibiting compound comprises hydroxylamine sulfate, hydroxylamine nitrate, hydroxylamine chloride, or mixtures thereof.

27. The method of claim 24, wherein the additive consumption inhibiting compound comprises from about 0.001 g/L to about 100 g/L of the bath.

28. The method of claim 24, further comprising brighteners, levelers, hardeners, wetting agents, malleability modifiers, ductility modifiers, deposition modifiers, suppressants or mixtures thereof.

29. The method of claim 24, wherein the brighteners comprise compounds of the formula: HO₃S-R¹¹-SH; HO₃S-R¹¹-S-S-R¹¹-SO₃H, where R¹¹ is C₁-C₆ or an aryl group; and HO₃-Ar-S-S-Ar-SO₃H, where Ar is phenyl or naphthyl; and the alkyl and aryl groups may be unsubstituted or substituted with an alkyl group, a halo or an alkoxy.

30. The method of claim 24, wherein the current density is from about 1 ASF to about 1000 ASF.

31. The method of claim 24, wherein the substrate comprises a printed wiring board, and integrated circuit, an electrical contact surface, a connector, an electrolyte foil, a silicon wafer, a semi-conductor, a lead frame, a optoelectronic component, a solder bump on a wafer, a decorative article, a sanitary appliance and the like.

32. A method for electroplating copper metal on a substrate comprising: contacting the substrate with a metal plating bath; and applying sufficient current density to the plating bath to deposit the copper on the substrate; the copper metal plating bath comprises a copper salt and an additive consumption inhibiting compound having the formula:
(R¹-NHR²OH)ₙX
where R¹ and R² are each independently hydrogen, or C₁-C₆ alkyl, n is 1 or 2, when n is 1, X is HSO₄⁻, H₂PO₄⁻, NO₃⁻, F Cl⁻, Br⁻, I⁻, and when n is 2, X is SO₄²⁻.

33. The method of claim 32, wherein the C₁-C₆ alkyl comprises methyl, ethyl, propyl, isopropyl, butyl,isobutyl, sec-butyl, tert-butyl, pentyl, isopentyl, neopentyl, tert-pentyl, hexyl, isohexyl, 3-methylpentyl, 2,2-dimethylbutyl, or 2,3-dimethylbutyl.

34. The method of claim 32, wherein the additive consumption inhibiting compound comprises hydroxylamine sulfate, hydroxylamine nitrate, hydroxylamine chloride, or mixtures thereof.

35. The method of claim 32, wherein the additive consumption inhibiting compound comprises from about 0.001 g/L to about 100 g/L of the bath.

36. The method of claim 32, further comprising brighteners, levelers, hardeners, wetting agents, malleability modifiers, ductility modifiers, deposition modifiers, suppressants or mixtures thereof.

37. The method of claim 36, wherein the brighteners comprise compounds of the formula: HO₃S-R¹¹-SH; HO₃S-R¹¹-S-S-R¹¹, where R¹¹ is C₁-C₆ alkyl or an aryl group; or HO₃-Ar-S-S-Ar-SO₃H, where Ar is phenyl or naphthyl; the C₁-C₆ alkyl and aryl group may be unsubstituted or substituted with an alkyl group, halo or alkoxy group.

38. The method of claim 32, wherein the substrate comprises a printed wiring board, an integrated circuit, an electrical contact surface, a connector, an electrolytic foil, a silicon wafer, a semi-conductor, a lead frame, a optoelectronic component, a solder bump on a wafer, a decorative article, a sanitary appliance, and the like.

39. The method of claim 32, wherein the current density is from about 1ASF to about 1000 ASF.

40. An apparatus comprising an electrical power source electrically connected to an anode and a cathode such that an electrical current can pass through the anode and cathode, the anode and the cathode are in contact with a metal plating bath such that when the electrical power source is operative a metal from the plating bath plates onto the cathode, the metal plating bath comprises a salt of a metal of copper, gold, silver, palladium, platinum, cobalt, cadmium, chromium, nickel, bismuth, indium, tin, rhodium, lead, ruthenium, iridium, or alloys thereof and an additive consumption inhibiting compound having the formula:
(R¹-NHR²OH)ₙX
where R¹ and R² are each independently hydrogen, or C₁-C₆ alkyl, and n is 1 or 2, when n is 1, X is HSO₄⁻, H₂PO₄⁻, NO₃⁻, F⁻, Cl⁻, Br⁻ or I⁻, and when n is 2, X is SO₄²⁻.

41. The apparatus of claim 40, wherein the additive consumption inhibiting compound comprises from about 0.01 g/L to about 20.0 g/L of the bath.

42. The apparatus of claim 40, wherein the metal plating bath further comprises brighteners, levelers, hardeners, wetting agents, malleability modifiers, ductility modifiers, deposition modifiers, suppressors or mixtures thereof.

43. The apparatus of claim 40, wherein the anode is an insoluble or soluble anode.

44. The apparatus of claim 43, wherein the insoluble anode comprises metals of cobalt, nickel, ruthenium, rhodium, palladium, iridium, or platinum.

45. The apparatus of claim 44, wherein the insoluble anode further comprises metals of titanium, zirconium, hafnium, vanadium, niobium, or tantalum.

46. The apparatus of claim 45, wherein the insoluble anode further comprises beryllium, calcium, strontium, barium, scandium, yttrium, lanthanum, or rare earth elements.

47. The apparatus of claim 43, wherein the insoluble anode comprises tantalum with a coating of iridium dioxide.

48. The apparatus of claim 40, wherein the cathode comprises a wiring board, an integrated circuit, an electrical contact surface, a connector, an electrolytic foil, a silicon wafer, a semi-conductor, a lead frame, an optoelectronic component, a solder bump, a decorative article, a sanitary appliance and the like.
